# EUROPEAN PATENT APPLICATION

(11) **EP 2 538 556 A1**
(43) Date of publication of application: **26.12.2012**
(21) Application number: 11832076.1
(22) Date of filing: 27.10.2011
(51) Int. Cl.: H03F 3/20

(54) **POWER AMPLIFICATION TUBE AND POWER AMPLIFICATION METHOD**

(30) Priority: 29.04.2011 CN 201110110892
(71) Applicant: ZTE Corporation, Shenzhen, Guangdong 518057 (CN)
(72) Inventor: HE, Gang, Nanshan District, Shenzen City Guangdong Province 518057 (CN); CHEN, Huazhang, Nanshan District, Shenzen City Guangdong Province 518057 (CN); CUI, Xiaojun, Nanshan District, Shenzen City Guangdong Province 518057 (CN)
(74) Representative: Novagraaf Technologies
(86) International application number: PCT/CN2011/081387
(87) International publication number: WO 2012/146003

(57) **Abstract**

A power amplifier tube and a power amplification method are disclosed in the present invention. The power amplifier tube includes a high voltage heterojunction bipolar transistor (HVHBT) power amplifier die and a high electron mobility transistor (HEMT) power amplifier die, and the HVHBT power amplifier die and the HEMT power amplifier die are integrated in the same encapsulation. In the present invention, it should be configured as a Doherty amplifier, and the power tube is designed in a breakthrough combination manner of new power amplifier dies, compared with all the existing Doherty amplifiers which employ LDMOS power amplifier dies, the power amplification with high efficiency can be achieved on the basis of ensuring small volume of power amplifier tube.

## Description

### Technical Field

The present invention relates to the technical field of radio frequency power amplifier design, and particularly, to a power amplifier tube and a power amplification method.

### Background of the Related Art

With the rapid increasing of mobile communication services, the requirements on the performance of the corresponding devices, such as low power consumption, high efficient, small volume, also rapidly increase, and the efficiency and volume of the base station products have become the focus of the industry competition, and the efficiency improvement of the main component deciding efficiency in the base station, i.e. power amplification device, also becomes a core point.

The radio frequency power amplifier is widely applied in various radio transmitting devices, and efficiency and linearity are two most important indicators of power amplifier, and to design a linear and high efficient power amplifier is the hot spot and difficulty point in the research of this field. Doherty amplifier technology currently is the most efficient and most widely used technology for improving the efficiency of the power amplifier.

Doherty technology is initially used in travelling wave tubes and provides a large power transmitter for broadcast, and the architecture thereof is simple and feasible and the efficiency thereof is high.

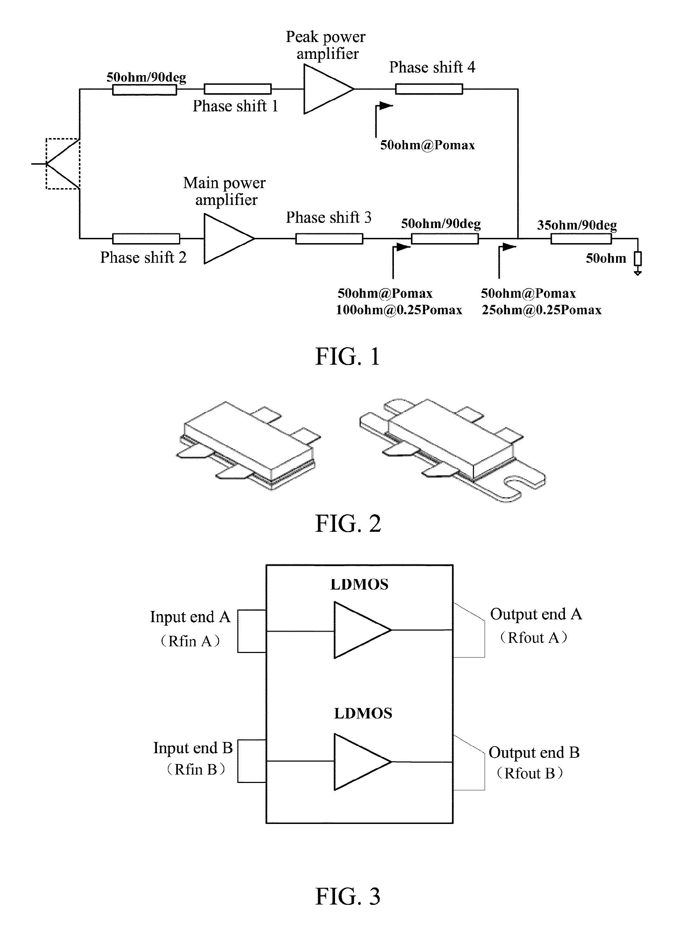

The conventional Doherty structure is composed of 2 power amplifiers: one is main power amplifier (also referred to as carrier power amplifier), and the other is auxiliary power amplifier (also referred to as peak power amplifier), with the main power amplifier operating in class B or class AB, and the auxiliary power amplifier operating in class C. These two power amplifiers do not operate in turn, instead the main power amplifier operates all the time, and the auxiliary power amplifier doesn't operate until a set peak is reached (so the auxiliary power amplifier is also referred to as peak power amplifier). The function of a quarter wavelength line at 90 degree after the output end of the main power amplifier is resistance transform, and the object is to play the role of reducing the apparent resistance of the main power amplifier when the auxiliary power amplifier operates and ensure that the resistance of the active load composed of the main power amplifier and the subsequent circuits is reduced when the auxiliary power amplifier operates, so that the output current of the main power amplifier is increased. Due to a quarter wavelength line after the output end of the main power amplifier, in order to make the outputs of two power amplifiers have the same phase, 90 degree phase shift is also required in front of the auxiliary power amplifier, as shown in FIG. 1.

The main power amplifier operates in class B, and when the total input signal is weak, only the main power amplifier is in the operating state; and when the output voltage of the main power amplifier reaches the peak saturation point, the theoretic efficiency of the power amplifier can reach 78.5%. If the excitation is doubled at this moment, then saturation occurs when the main power amplifier tube reaches half of the peak, and the efficiency of the power amplifier also reaches the maximum 78.5%, at this moment, the auxiliary power amplifier starts to operate together with the main power amplifier. The introduction of auxiliary power amplifier reduces the load from the view of the main power amplifier, that is because the action of the auxiliary power amplifier on the load is equivalent to be in series with one negative resistor, even the output voltage of the main power amplifier is saturated and stable, the output power continuously increase due to the decreasing of load (the current passing through the load increases). When the peak of the excitation is reached, the auxiliary power amplifier also reaches the maximum point of its own efficiency, thus the efficiency after these two power amplifiers are put together is far higher than the efficiency of a single class B power amplifier. The maximum efficiency 78.5% of a single class B power amplifier occurs at the peak, but now, the efficiency 78.5% occurs at half of the peak, therefore such a system structure can reach a very high efficiency (each amplifier reaches the maximum output efficiency).

The conventional Doherty amplifier is implemented by the combination of two power amplifier tubes with the same type and independently encapsulated which are a main amplifier and a peak amplifier respectively, and currently, what is most employed in the industries is Laterally Diffused Metal Oxide Semiconductor (abbreviated as LDMOS) power amplifier tube. The supply voltages and biasing manners of the power amplifier tubes with the same type are the same, therefore, the design of the biasing circuit is simple; and since various power amplifier tubes are of the same type, it is also relatively easy to control the discretion of the batch production thereof. However, the design layout area of two independently encapsulated power amplifier tubes is also quite large, which cannot meet the requirements of small volume.

As to such situation, various power amplifier tube manufactures made lots of researches and developed a power amplifier tube with high efficiency and small volume with respect to the Doherty technology, such as dual end device of Freescale, as shown in FIG. 2. Such a device is integrated with two independent power amplifier tubes in one encapsulation (currently, both of them are LDMOS power amplifier tubes, which can be respectively used as the Carrier amplifier and Peak amplifier of the Doherty amplifier, and its internal structure is as shown in FIG. 3), and a Doherty amplifier with small volume can be flexibly achieved, however, due to the use of LDMOS power amplifier tube, and the LDMOS device has developed to the 8^{th} generation, even though its costs are low, the improvement space of its performance is quite limited, which cannot meet the environment-friendly requirements. Therefore, how to design a power amplifier tube with small volume and high efficiency with respect to Doherty application is a technical problem to be solved.

### Summary of the Invention

The technical problem to be solved by the present invention is to provide a power amplifier tube and a power amplification method, so as to achieve power amplification with high efficiency on the basis of small-volume power amplifier tube.

In order to solve the above technical problem, the present invention provides a power amplifier tube applied in a Doherty power amplifier apparatus, and the power amplifier tube comprises a high voltage heterojunction bipolar transistor (HVHBT) power amplifier die and a high electron mobility transistor (HEMT) power amplifier die, and the HVHBT power amplifier die and the HEMT power amplifier die are integrated in the same encapsulation.

Optionally, when the power amplifier tube is an amplifier tube with dual-path structure, one path is configured to employ the HVHBT power amplifier die and the other path is configured to employ the HEMT power amplifier die.

Optionally, in this case, when the power amplifier tube is an amplifier tube with multi-path structure,
one path is configured to employ the HVHBT power amplifier die and the remaining paths are configured to employ the HEMT die, or
one path is configured to employ the HEMT power amplifier die and the remaining paths are configured to employ the HVHBT die.

Optionally, the HVHBT is based on GaAs, and the HEMT is based on GaN.

The present invention also provides a power amplifier tube applied in a Doherty power amplifier apparatus, and the power amplifier tube comprises an auxiliary power amplifier and a main power amplifier, wherein
the auxiliary power amplifier and main power amplifier are integrated in the same encapsulation where the power amplifier tube is located; and
in the auxiliary power amplifier and main power amplifier in the power amplifier tube, some power amplifiers are configured to employ HVHBT devices to amplify the signal power, and other power amplifiers are configured to employ HEMT devices to amplify the signal power.

Optionally, when the power amplifier tube is an amplifier tube with dual-path structure, the auxiliary power amplifier is configured to employ an HVHBT device and the main power amplifier is configured to employ an HEMT device, or the auxiliary power amplifier is configured to employ an HEMT device and the main power amplifier is configured to employ an HVHBT device.

Optionally, when the power amplifier tube is an amplifier tube with multi-path structure, some auxiliary power amplifiers are configured to employ HVHBT devices and other auxiliary power amplifiers and the main power amplifier are configured to employ HEMT devices, or, the main power amplifier is configured to employ an HVHBT device and the auxiliary power amplifier is configured to employ an HEMT device, or the main power amplifier and some auxiliary power amplifiers are configured to employ HVHBT devices and other auxiliary power amplifiers are configured to employ HEMT devices.

Optionally, the HVHBT device is a device based on GaAs, and the HEMT device is a device based on GaN.

The present invention also provides a power amplification method, comprising:
amplifying signal power by using an HVHBT power amplifier die and an HEMT power amplifier die, and the HVHBT power amplifier die and HEMT power amplifier die being integrated in the same encapsulation of power amplifier tube.

Optionally, when the power amplifier tube is an amplifier tube with dual-path structure, one path is configured to employ the HVHBT power amplifier die and the other path is configured to employ the HEMT power amplifier die.

Optionally, when the power amplifier tube is an amplifier tube with multi-path structure, one path is configured to employ the HVHBT power amplifier die and remaining paths are configured to employ the HEMT power amplifier die, or one path is configured to employ the HEMT power amplifier die and remaining paths are configured to employ the HVHBT power amplifier die.

Optionally, the method further comprises:
selecting the HVHBT device and the HEMT device according to power amplification parameters of the power amplifier tube.

The present invention also provides another power amplification method, comprising:
integrating an auxiliary power amplifier and a main power amplifier into the same encapsulation where a power amplifier tube is located; in the auxiliary power amplifier and main power amplifier of the power amplifier tube, some power amplifiers employing HVHBT devices to amplify signal power, and other amplifiers employ HEMT devices to amplify signal power.

Optionally, when the power amplifier tube is an amplifier tube with dual-path structure, the auxiliary power amplifier employs an HVHBT device and the main power amplifier employs an HEMT device, or the auxiliary power amplifier employs an HEMT device and the main power amplifier employs an HVHBT device.

Optionally, when the power amplifier tube is an amplifier tube with multi-path structure, some auxiliary power amplifiers employ HVHBT devices and other auxiliary power amplifiers and the main power amplifier employ HEMT devices, or, the main power amplifier employ an HVHBT device and the auxiliary power amplifier employs an HEMT device, or the main power amplifier and some auxiliary power amplifiers employ HVHBT devices, and other auxiliary power amplifiers employ HEMT devices.

The above solution is applied in a Doherty amplifier, and the power tube is designed in a breakthrough combination manner of new power amplifier dies, compared with all the existing Doherty amplifiers which employ LDMOS power amplifier dies, the power amplification with high efficiency can be achieved on the basis of ensuring small volume of power amplifier tube.

### Brief Description of Drawings

FIG. 1 is a structure diagram of a conventional Doherty power amplifier;
FIG. 2 is an outline diagram of an independently encapsulated dual-path power amplifier tube in the related art;
FIG. 3 is a structural schematic diagram of power amplifier tube with dual-path structure in the related art; and
FIG. 4 is a structural schematic diagram of power amplifier tube with dual-path structure according to the present embodiment.

### Preferred Embodiments of the Present Invention

The power amplifier tube in the embodiments of the present invention is applied in a Doherty power amplification apparatus, and the power amplifier tube comprises a high voltage heterojunction bipolar transistor (HVHBT) power amplifier die and a high electron mobility transistor (HEMT) power amplifier die, and the HVHBT power amplifier die and the HEMT power amplifier die are integrated in the same encapsulation.

In this case, the HVHBT device refers to the HBT process equipment which can operate under high voltage, and this high voltage refers to an operation voltage above 12 V. It includes but not limited to the Tripower series of power amplifier devices of American Triquint cooperation.

The HVHBT device can be a device based on GaAs. The HEMT device can be a device based on GaN.

Optionally, the power amplifier tube includes a main power amplifier and an auxiliary power amplifier.

The main power amplifier and auxiliary power amplifier are integrated in the same encapsulation where the power amplifier tube is located; one or more amplifiers in the main power amplifier and auxiliary power amplifier in the power amplifier tube are configured to employ high voltage heterojunction bipolar transistor (HVHBT) devices to amplify the signal power, and other amplifiers are configured to employ high electron mobility transistor (abbreviated as HEMT) devices to amplify the signal power.

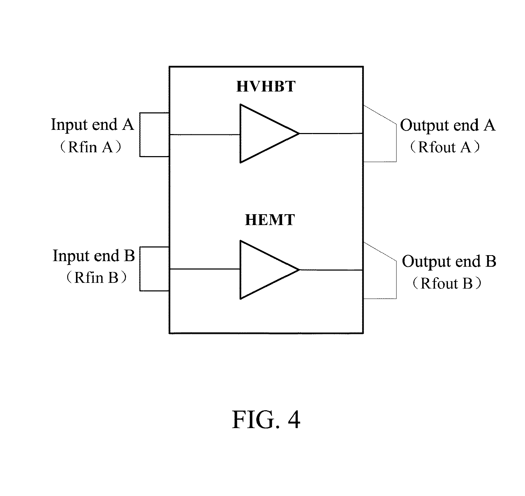

In embodiment I, as shown in FIG. 4, when the power amplifier tube is an amplifier tube with dual-path structure, one path is configured to employ an HVHBT die and the other path is configured to employ an HEMT die. The two power amplifier dies are integrated into the same encapsulation of power amplifier tube to improve the high efficiency of the power amplifier while ensuring the small volume of the power amplifier tube.

In embodiment II, when the power amplifier tube is an amplifier tube with multi-path structure, one path is configured to employ an HVHBT die and other paths are configured to employ LDMOS dies, or one path is configured to employ an LDMOS die and other paths are configured to employ HEMT dies. The multi-path power amplifier dies are integrated into the same encapsulation of power amplifier tube to improve the high efficiency of the power amplifier while ensuring the small volume of the power amplifier tube.

The HVHBT device is a device based on GaAs, and the HEMT device is a device based on GaN.

The power amplification method in the present invention comprises: integrating an HVHBT power amplifier die and an HEMT power amplifier die into the same encapsulation of the power amplifier tube.

Optionally, a main power amplifier and an auxiliary power amplifier are integrated into the same encapsulation where the power amplifier tube is located; in the auxiliary power amplifier and main power amplifier of the power amplifier tube, one or more power amplifiers employ HVHBT devices to amplify the signal power, and other amplifiers employ HEMT devices to amplify the signal power.

In embodiment I, as shown in FIG. 4, when the power amplifier tube is an amplifier tube with dual-path structure, the auxiliary power amplifier employs an HVHBT device and the main power amplifier employs an HEMT device, or the auxiliary power amplifier employs an HEMT device and the main power amplifier employs an HVHBT device. The two power amplifier dies are integrated into the same encapsulation of the power amplifier tube to improve the high efficiency of the power amplifier while ensuring the small volume of the power amplifier tube.

In embodiment II, when the power amplifier tube is an amplifier tube with multi-path structure, one or more auxiliary power amplifiers employ HVHBT devices and other auxiliary power amplifiers and the main power amplifier employ HEMT devices, or, the main power amplifier employ an HVHBT device and the auxiliary power amplifier employs an HEMT device, or the main power amplifier and one or more auxiliary power amplifiers employ HVHBT devices and other auxiliary power amplifiers employ HEMT devices. The multi-path power amplifier dies are integrated into the same encapsulation of the power amplifier tube to improve the high efficiency of the power amplifier while ensuring the small volume of the power amplifier tube.

The HVHBT device is a device based on GaAs, and the HEMT device is a device based on GaN.

In the above method, the HVHBT device and HEMT device are selected according to power amplification parameters of the power amplifier tube.

When designing the Doherty power amplifier, the used HVHBT power amplifier die model number and HEMT power amplifier die model number are determined according to the required power amplification parameters; the structure of the Doherty power amplifier is determined (dual-path or multi-path), two dies are integrated into the same encapsulation structure and the inner match design and tube housing encapsulation are completed, and this Doherty power amplifier is used to amplify the signal.

### Application examples:

As to the Doherty power amplifier design of 2.1 GHz UMTS system application with power of 55 W and the peak to average power ratio of 6 dB, two independently encapsulated power amplifier tubes are required to reach a saturation power of totaling at least 200 W. In combination with the existing devices of the power amplifier tube manufactures, it can be implemented by using two 120W LDMOS power amplifier tubes by way of a symmetric Doherty structure, and according to the current device level in the industries, its single and final stage of power amplification efficiency is about 52%; when it is implemented on the basis of the embodiments of the present invention, its single and final stage of power amplification efficiency is about 58%, improved by about 12%, and the PCB design layout area can be reduced in half.

The embodiments of the present invention employ a new breakthrough combination manner of power amplifier dies, in which an HVHBT die and an LDMOS die are integrated into the same encapsulation to improve power amplification efficiency while achieving small volume. During particular implementation, making full use of the advantage of high efficiency of the HVHBT power amplifier die, the HVHBT die is taken as the main amplifier of the Doherty amplifier to achieve optimized performance. At the same time, advantages of the high maturity and low cost of the LDMOS power amplifier die technology are used to achieve optimized costs and finally achieve perfect combination of performance, costs, and volume. The embodiments of the present invention can be widely applied in various Doherty amplifier designs to significantly improve its efficiency indicator.

It needs to note that the embodiments of the present application and the features in the embodiments can be combined with each other at random if there is no conflict.

Of course, the present invention can have several other embodiments, and those skilled in the art can make various corresponding modifications and variations according to the present invention without departing from the spirit and essence of the present invention, and these corresponding modifications and variations shall belong to the protection scope of the appended claims of the present invention.

It will be understood by those skilled in the art the all or part of the steps in the above method can be completed by means of program instructing relevant hardware, and the program may be stored in computer readable storage medium, such as read only memory, magnet or optical disk and so on. Alternatively, the all or part of steps in the above embodiments can be implemented by means of one or more integrated circuits. Accordingly, the respective module/unit in the above embodiments can be implemented in the form of the hardware or the software function module. In this way, the present invention is not limited to any particular form of combination of hardware and software.

### Industrial Applicability

The above embodiments are applied in a Doherty amplifier, and the power tube is designed in a breakthrough combination manner of new power amplifier dies, and compared with all the existing Doherty amplifiers which employ LDMOS power amplifier dies, the power amplification with high efficiency can be achieved on the basis of ensuring small volume of power amplifier tube.

## Claims

1. A power amplifier tube applied in a Doherty power amplifier apparatus, comprising a high voltage heterojunction bipolar transistor (HVHBT) power amplifier die and a high electron mobility transistor (HEMT) power amplifier die, and the HVHBT power amplifier die and the HEMT power amplifier die being integrated in the same encapsulation.

2. The power amplifier tube as claimed in claim 1, wherein
when the power amplifier tube is an amplifier tube with dual-path structure, one path is configured to employ the HVHBT power amplifier die and the other path is configured to employ the HEMT power amplifier die.

3. The power amplifier tube as claimed in claim 1, wherein when the power amplifier tube is an amplifier tube with multi-path structure,
one path is configured to employ the HVHBT power amplifier die and remaining paths are configured to employ a HEMT die, or
one path is configured to employ the HEMT power amplifier die and remaining paths are configured to employ the HVHBT die.

4. The power amplifier tube as claimed in any one of claims 1 to 3, wherein
the HVHBT is based on GaAs, and the HEMT is based on GaN.

5. A power amplifier tube applied in a Doherty power amplifier apparatus, comprising an auxiliary power amplifier and a main power amplifier, wherein
the auxiliary power amplifier and main power amplifier are integrated in the same encapsulation where the power amplifier tube is located; and
in the auxiliary power amplifier and main power amplifier in the power amplifier tube, some power amplifiers are configured to employ a high voltage heterojunction bipolar transistor (HVHBT) device to amplify signal power, and other power amplifiers are configured to employ a high electron mobility transistor (HEMT) device to amplify signal power.

6. The power amplifier tube as claimed in claim 5, wherein
when the power amplifier tube is an amplifier tube with dual-path structure, the auxiliary power amplifier is configured to employ the HVHBT device and the main power amplifier is configured to employ the HEMT device, or the auxiliary power amplifier is configured to employ the HEMT device and the main power amplifier is configured to employ the HVHBT device.

7. The power amplifier tube as claimed in claim 5, wherein
when the power amplifier tube is an amplifier tube with multi-path structure, some auxiliary power amplifiers are configured to employ the HVHBT devices and other auxiliary power amplifiers and the main power amplifier are configured to employ the HEMT devices, or, the main power amplifier is configured to employ the HVHBT device and the auxiliary power amplifier is configured to employ the HEMT device, or the main power amplifier and some auxiliary power amplifiers are configured to employ the HVHBT devices and other auxiliary power amplifiers are configured to employ the HEMT devices.

8. The power amplifier tube as claimed in any one of claims 5 to 7, wherein
the HVHBT device is a device based on GaAs, and the HEMT device is a device based on GaN.

9. A power amplification method, comprising:
amplifying signal power by using a high voltage heterojunction bipolar transistor (HVHBT) power amplifier die and a high electron mobility transistor (HEMT) power amplifier die, and the HVHBT power amplifier die and HEMT power amplifier die being integrated in the same encapsulation of power amplifier tube.

10. The method as claimed in claim 9, wherein when the power amplifier tube is an amplifier tube with dual-path structure, one path is configured to employ the HVHBT power amplifier die and the other path is configured to employ the HEMT power amplifier die.

11. The method as claimed in claim 9, wherein when the power amplifier tube is an amplifier tube with multi-path structure, one path is configured to employ the HVHBT power amplifier die and remaining paths are configured to employ the HEMT power amplifier die, or one path is configured to employ the HEMT power amplifier die and remaining paths are configured to employ the HVHBT power amplifier die.

12. The method as claimed in any one of claims 9 to 11, further comprising:
selecting the HVHBT device and the HEMT device according to power amplification parameters of the power amplifier tube.

13. A power amplification method, comprising:
integrating an auxiliary power amplifier and a main power amplifier into the same encapsulation where a power amplifier tube is located; in the auxiliary power amplifier and main power amplifier of the power amplifier tube, some power amplifiers employing HVHBT devices to amplify signal power, and other amplifiers employ HEMT devices to amplify signal power.

14. The method as claimed in claim 13, wherein
when the power amplifier tube is an amplifier tube with dual-path structure, the auxiliary power amplifier employs the HVHBT device and the main power amplifier employs the HEMT device, or the auxiliary power amplifier employs the HEMT device and the main power amplifier employs the HVHBT device.

15. The method as claimed in claim 13, wherein
when the power amplifier tube is an amplifier tube with multi-path structure, some auxiliary power amplifiers employ the HVHBT devices and other auxiliary power amplifiers and the main power amplifier employ the HEMT devices, or, the main power amplifier employ the HVHBT device and the auxiliary power amplifier employs the HEMT device, or the main power amplifier and some auxiliary power amplifiers employ the HVHBT devices and other auxiliary power amplifiers employ the HEMT devices.
